(19) Europäisches Patentamt
European Patent Office
Office européen des brevets

(11) **EP 4 167 486 A1**

(12) **EUROPÄISCHE PATENTANMELDUNG**

(43) Veröffentlichungstag:
**19.04.2023 Patentblatt 2023/16**

(21) Anmeldenummer: **22197048.6**

(22) Anmeldetag: **22.09.2022**

(51) Internationale Patentklassifikation (IPC):
**H03K 17/96** (2006.01)

(52) Gemeinsame Patentklassifikation (CPC):
**H03K 17/962;** H03K 2217/960705

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(30) Priorität: **12.10.2021 DE 102021211480**

(71) Anmelder: **BSH Hausgeräte GmbH
81739 München (DE)**

(72) Erfinder:
• **Stadler, Dominik
93128 Regenstauf (DE)**
• **Zei, Carsten
93161 Sinzing (DE)**
• **Fischer, Oliver
81547 München (DE)**
• **Rötzer, Florian
92431 Neunburg (DE)**

(54) **BEDIENVORRICHTUNG FÜR EIN GERÄT**

(57) Eine Bedienvorrichtung umfasst eine Sensorfläche; einen Signalgenerator zur Bereitstellung eines Ansteuersignals mit einer vorbestimmten Frequenz für die Sensorfläche; eine Auswertevorrichtung, die dazu eingerichtet ist, ein von der Kapazität der Sensorfläche abhängiges Sensorsignal bereitzustellen; und eine Steuereinrichtung. Dabei ist die Steuereinrichtung dazu eingerichtet, Messrauschen an der Auswertevorrichtung unter verschiedenen Frequenzen zu bestimmen und die Frequenz des Ansteuersignals zur Bestimmung des Sensorsignals in Abhängigkeit des bestimmten Messrauschens zu wählen.

Fig. 2

EP 4 167 486 A1

**Beschreibung**

Die Erfindung betrifft eine Bedienvorrichtung für ein Gerät. Insbesondere betrifft die Erfindung eine Bedienvorrichtung mit einem kapazitiven Berührungssensor zur Steuerung eines Geräts.

Ein Haushaltsgerät, beispielsweise ein Herd, ist dazu eingerichtet, ein Kochgeschirr zu erwärmen. Die Erwärmung kann mittels einer Bedienvorrichtung in ihrer Stärke gesteuert werden. Die Bedienvorrichtung umfasst eine Elektrode, deren Berührung durch einen Benutzer bestimmt wird, indem erfasst wird, wie sich die Kapazität der Elektrode ändert. Dazu kann die Elektrode mit einem Ansteuersignal mit einer vorbestimmten Frequenz beaufschlagt werden und ein Lade- bzw. Entladeverhalten der Elektrode kann bestimmt werden.

Eine solche Bedienvorrichtung kann durch eine Vielzahl Einflüsse, die im Bereich des Geräts vorliegen können, gestört werden. Beispielsweise kann ein hoch- oder niederfrequentes elektromagnetisches Signal kabelgebunden oder drahtlos eingekoppelt werden, sodass eine Auswertevorrichtung unzuverlässige Bestimmungen bereitstellen kann.

Es wurde vorgeschlagen, die Frequenz des Ansteuersignals nach einem vorbestimmten Muster zu ändern. Eine Wahrscheinlichkeit, dass eine vorliegende Störungsquelle Signale mit allen verwendeten Frequenzen des Ansteuersignals abdeckt, kann gering sein.

Diese Entstörmethode kann jedoch nicht unter allen Umständen zufriedenstellende Resultate liefern. Es wurde vorgeschlagen, einen zeitlichen Mittelwert bestimmter Kapazitäten zu verwenden, um eine Berührung zu erfassen. Dadurch kann eine gute Unterdrückung von Störungen realisiert werden. Nachteilig hierbei kann sein, dass ein Ansprechverhalten der Elektrode weniger spontan ist. Ein Benutzer, der eine sehr schnelle Reaktion einer Bedienvorrichtung gewöhnt ist, kann dies als unangenehm empfinden.

Eine der vorliegenden Erfindung zugrunde liegende Aufgabe besteht daher in der Bereitstellung einer verbesserten Technik zur Erkennung einer Berührung einer Sensorfläche zum Zweck des Steuerns eines Geräts. Die Erfindung löst diese Aufgabe mittels der Gegenstände der unabhängigen Ansprüche. Unteransprüche geben bevorzugte Ausführungsformen wieder.

Nach einem ersten Aspekt der vorliegenden Erfindung umfasst eine Bedienvorrichtung eine Sensorfläche; einen Signalgenerator zur Bereitstellung eines Ansteuersignals mit einer vorbestimmten Frequenz für die Sensorfläche; eine Auswertevorrichtung, die dazu eingerichtet ist, ein von der Kapazität der Sensorfläche abhängiges Sensorsignal bereitzustellen; und eine Steuereinrichtung. Dabei ist die Steuereinrichtung dazu eingerichtet, Messrauschen an der Auswertevorrichtung unter verschiedenen Frequenzen zu bestimmen und die Frequenz des Ansteuersignals zur Bestimmung des Sensorsignals in Abhängigkeit des bestimmten Messrauschens zu wählen.

Erfindungsgemäß wird die Frequenz nur dann geändert, wenn bestimmt werden kann, dass eine andere Frequenz vorteilhafter für die Bestimmung des Sensorsignals ist. Dadurch kann ein sehr schnelles Ansprechverhalten mit einer sehr guten Störfestigkeit kombiniert werden. Verwendete Frequenzen können ausreichend unterschiedlich voneinander sein, um eine gleichmäßige Störung durch eine Störungsquelle möglichst auszuschließen.

Das Messrauschen wird bevorzugt am Sensorsignal bestimmt. In einer bevorzugten Ausführungsform kann ein gleitender Durchschnitt über Messwerte des Sensorsignals bestimmt werden, wobei der gleitende Durchschnitt auf das Rauschen hinweist. Die Messwerte werden bevorzugt mit einer vorbestimmten Frequenz abgetastet. Der gleitende Durchschnitt kann Unterschiede zwischen aufeinanderfolgenden Messwerten umfassen. Die Unterschiede können über einen vorbestimmten Zeitraum hin aufsummiert und durch die Anzahl der in diesem Zeitraum erfassten Messwerte dividiert werden. Weiter bevorzugt kann die Differenz zwischen den aufeinanderfolgenden Messwerten als Betrag gewertet werden. Die Bestimmung des Messrauschens kann auf folgende Weise erfolgen:

$$N = \frac{\sum_{n=1}^{NumSamples}|val_{n-1} - val_n|}{NumSamples};$$

wobei gilt:

N := Messrauschen
NumSamples := eine Anzahl beachteter, aufeinander folgender Sensorsignale
val := ein bestimmtes Sensorsignal

In anderen Ausführungsformen kann auch eine andere auf das Messrauschen hinweisende Größe verwendet werden, beispielsweise ein Signal-Rausch-Verhältnis (auch: Störabstand; signal to noise ratio, SNR).

Die Steuereinrichtung ist bevorzugt dazu eingerichtet, eine Bestimmung des Sensorsignals bei Anregung der Sensorfläche mit einer primären Frequenz zu unterbrechen, um das Messrauschen bei Anregung der Sensorfläche mit einer sekundären Frequenz zu bestimmen. Die primäre und die sekundäre Frequenz können aus einer Anzahl vorbestimmter Frequenzen ausgewählt sein. Vorliegend wird ein Ansteuersignal der primären Frequenz zur Bestimmung des Sensorsignals verwendet. Ein Ansteuersignal mit der sekundären Frequenz wird bevorzugt periodisch, insbesondere intermittierend, evaluiert. Sollte sich herausstellen, dass das Messrauschen bei Verwendung eines Ansteuersignals mit der sekundären Frequenz kleiner als mit der primären Frequenz ist, so kann die sekundäre Frequenz als neue primäre Frequenz eingesetzt werden.

Eine Unterbrechung der Ansteuerung der Sensorfläche mit dem Ansteuersignal der primären Frequenz durch die Ansteuerung mit dem Ansteuersignal mit der sekundären Frequenz erfolgt bevorzugt periodisch. Dabei ist eine durchschnittliche Zeit, während der die sekundäre Frequenz verwendet wird, bevorzugt deutlich kleiner als eine Zeit, während der die primäre Frequenz verwendet wird. Ein Verhältnis von Zeiten der primären zur sekundären Frequenz kann im Bereich von 10 zu 1 oder höher liegen.

Das Bestimmen des Messrauschens bei Verwendung der sekundären Frequenz kann erst dann erfolgen, wenn das bestimmte Messrauschen bezüglich der primären Frequenz einen vorbestimmten Schwellenwert übersteigt. Dadurch kann die Bedienvorrichtung vollständig für die Bestimmung einer Berührung zur Verfügung stehen, während gute Bedingungen für deren Auswertung vorliegen. Erst wenn die Bedingungen schlechter werden, kann versucht werden, durch Wahl einer anderen Frequenz für das Ansteuersignal das Messrauschen zu verringern.

Die Auswertevorrichtung ist bevorzugt dazu eingerichtet, das Sensorsignal auf der Basis des Ansteuersignals mittels eines Sigma-Delta-Verfahrens zu bestimmen. Das Sensorsignal wird bevorzugt in digitaler Form bereitgestellt und kann einen vorbestimmten Wertebereich umfassen. Der Wertebereich kann in binärer Form mit einer Anzahl Bits ausgedrückt werden, beispielsweise ca. 12 bis 15, in einer besonders bevorzugten Ausführungsform ca. 13 Bit.

Es ist weiterhin bevorzugt, dass eine Bestimmungseinrichtung zur Bestimmung einer Berührung der Sensorfläche durch einen Benutzer auf der Basis des Sensorsignals vorgesehen ist. Bei der Bestimmung kann das Sensorsignal einem Tiefpass unterzogen sein, um eine nur kurzfristige Berührung oder eine Störung bei der Bestimmung der Kapazität der Sensorfläche möglichst zu ignorieren.

Es kann ein Treiber vorgesehen sein, der dazu eingerichtet ist, einen Verbraucher in Abhängigkeit der bestimmten Berührung anzusteuern. Der Treiber kann in unterschiedlichen Ausführungsformen vom Haushaltsgerät oder von der Bedienvorrichtung umfasst sein und ist bevorzugt dazu eingerichtet, eine mittels des Verbrauchers umgesetzte elektrische Leistung in Abhängigkeit der Berührung zu steuern. Weiter bevorzugt umfasst die Bedienvorrichtung mehrere Sensorflächen, die jeweils auf eine hierin beschriebene Weise bezüglich Berührungen durch einen Benutzer untersucht werden können. Der Verbraucher kann in Abhängigkeit eines Betriebsmodus gesteuert werden, wobei der Betriebsmodus auf der Basis einer oder mehrerer Berührungen einer oder mehrerer Sensorflächen bestimmt wird. Es können auch mehrere Verbraucher vorgesehen sein, die mittels einer oder mehrerer Sensorflächen gesteuert werden können.

Nach einem weiteren Aspekt der vorliegenden Erfindung umfasst ein Haushaltsgerät eine hierin beschriebene Bedienvorrichtung.

Nach wieder einem weiteren Aspekt der vorliegenden Erfindung umfasst ein Verfahren Schritte des Bereitstellens eines Ansteuersignals mit einer vorbestimmten Frequenz an einer Sensorfläche; des Bereitstellens eines von einer Kapazität der Sensorfläche abhängigen Sensorsignals; des Bestimmens von Messrauschen an der Auswertevorrichtung unter verschiedenen Frequenzen; und des Wählens der Frequenz des Ansteuersignals zur Bestimmung des Sensorsignals in Abhängigkeit des bestimmten Messrauschens.

Das Verfahren kann teilweise oder vollständig mittels einer hierin beschriebenen Bedienvorrichtung ausgeführt werden. Dazu kann das Verfahren als Computerprogrammprodukt mit Programmcodemitteln vorliegen. Das Computerprogrammprodukt kann auf einem computerlesbaren Datenträger gespeichert sein. Die Bedienvorrichtung kann zur Ausführung des Verfahrens einen programmierbaren Mikrocomputer oder Mikrocontroller umfassen. Vorteile oder Merkmale des Verfahrens können auf die Vorrichtung übertragen werden und umgekehrt.

Es ist weiter bevorzugt, dass mehrere Frequenzen vorbestimmt sind; wobei zur Bestimmung des Sensorsignals eine primäre Frequenz für das Ansteuersignal verwendet wird. Eine Bestimmung des Messrauschens bei der sekundären Frequenz kann erst erfolgen, wenn das Messrauschen bei der primären Frequenz einen vorbestimmten Schwellenwert erreicht. Die sekundäre Frequenz kann auch periodisch als Ansteuersignal verwendet werden, um ein dabei geltendes Messrauschen zu bestimmen. Beide Frequenzen können aus einer vorbestimmten Auswahl von Frequenzen gewählt sein. In einer bevorzugten Ausführungsform sind nur zwei Frequenzen vorbestimmt, deren Rollen als primäre und sekundäre Frequenzen getauscht werden können, sodass jeweils die Frequenz, bei der das geringere Messrauschen auftritt, zur Bestimmung einer Berührung der Sensorfläche verwendet werden kann.

In einer anderen Ausführungsform können auch mehr als zwei Frequenzen vorgesehen sein. Eine der Frequenzen kann als primäre Frequenz und eine oder mehrere andere als sekundäre Frequenzen bestimmt werden. Sollte das Messrauschen auf der primären Frequenz einen vorbestimmten Schwellenwert übersteigen, so kann eine der anderen Frequenzen als primäre Frequenz bestimmt werden. Der Schwellenwert kann fest vorbestimmt sein oder ein Messrauschen bei einer der anderen Frequenzen betreffen.

In einer besonders bevorzugten Ausführungsform wird das Messrauschen unter Verwenden der sekundären Frequenz erst bestimmt, wenn das Messrauschen unter Verwenden der primären Frequenz einen vorbestimmten Schwellenwert übersteigt. Der Schwellenwert kann absolut oder relativ mit Bezug auf das Sensorsignal vorgegeben sein.

Die Erfindung wird nun unter Bezug auf die beiliegenden Figuren genauer beschrieben, in denen:

Figur 1    ein Haushaltsgerät;

Figur 2    ein Ablaufdiagramm eines Verfahrens zum Steuern eines Geräts; und

Figur 3    ein beispielhaftes Sensorsignal

darstellt.

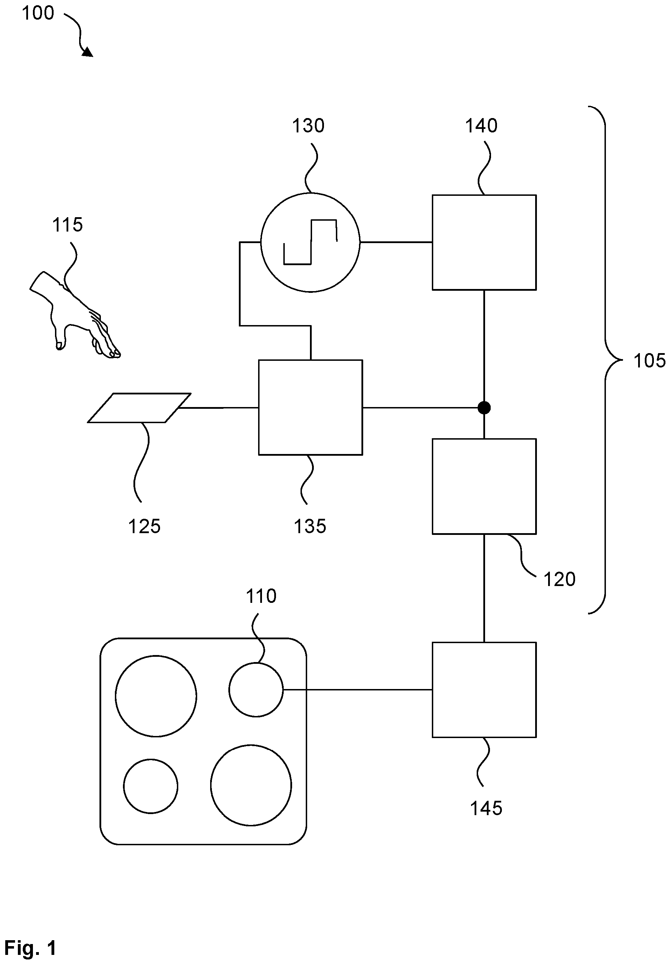

Figur 1 zeigt ein Haushaltsgerät 100 mit einer Bedienvorrichtung 105. Rein beispielhaft ist das Haushaltsgerät 100 als Herd dargestellt. Das Haushaltsgerät 100 umfasst einen oder mehrere Verbraucher 110, wobei vorliegend ein Verbraucher 110 einer Heizeinrichtung für ein Kochgefäß entsprechen kann.

Die Bedienvorrichtung 105 ist dazu eingerichtet, eine Berührung durch einen Benutzer 115 zu erfassen und den Verbraucher 110 in Abhängigkeit der Berührung zu steuern. Zur Bestimmung einer Berührung und gegebenenfalls zur Umsetzung eines Steuersignals in eine mittels des Verbrauchers 110 erbrachte Funktion kann eine Bestimmungseinrichtung 120 vorgesehen sein.

Die Bedienvorrichtung 105 umfasst eine Sensorfläche 125, einen Signalgenerator 130, eine Auswertevorrichtung 135 und eine Steuereinrichtung 140. Der Signalgenerator 130 ist dazu eingerichtet, die Sensorfläche 125 mit einem Ansteuersignal in einer vorbestimmten Frequenz zu versorgen. Die Auswertevorrichtung 135 ist dazu eingerichtet, ein auf eine Kapazität der Sensorfläche 125 hinweisendes Sensorsignal bereitzustellen. Die Steuereinrichtung 140 ist dazu eingerichtet, den Signalgenerator 130 zu steuern, um eine Frequenz des Ansteuersignals anzupassen. Außerdem kann die Steuereinrichtung 140 ein Messrauschen im Sensorsignal der Auswertevorrichtung 135 bestimmen. Die Auswertevorrichtung 135 kann dazu eingerichtet sein, einen Einfluss der Frequenz des Ansteuersignals auf das bestimmte Sensorsignal zu kompensieren.

Optional ist ein Treiber 145 vorgesehen, um den Verbraucher 110 auf der Basis eines durch die Bestimmungseinrichtung 120 bereitgestellten Signals zu steuern. Im Fall eines Induktionsherds kann der Treiber 145 eine Ansteuerung für eine induktive Spule 110 umfassen. An einem Strahlungs-Kochfeld kann der Treiber 145 eine Phasenanschnittsteuerung umfassen. Der Treiber 145 kann auch beispielsweise ein halbleiterbasiertes Stromventil (Solid State Relais) oder ein Relais umfassen.

In einer bevorzugten Ausführungsform wird ein Modulationskondensator mittels einer Stromquelle aufgeladen. Ladung aus dem Modulationskondensator wird dann in einen mit der Sensorfläche 125 gebildeten Kondensator umgeladen, anschließend wird der Kondensator durch Kurzschließen wieder entladen. Dabei ist die Kapazität des Modulationskondensators bevorzugt wenigstens eine Größenordnung größer als die des mit der Sensorfläche 125 gebildeten Kondensators. Das Aufladen des Kondensators aus dem Modulationskondensator und das Entladen wird periodisch mit einer vorbestimmten Frequenz wiederholt, während gleichzeitig eine Spannung des Modulationskondensators überwacht wird. Dabei wird gezählt, wie oft der Kondensator aus dem Modulationskondensator aufgeladen werden kann, bis dessen Spannung unter einen vorbestimmten Schwellenwert fällt. Die bestimmte Anzahl kann als Hinweis auf die Kapazität des Kondensators und damit auf eine Berührung der Sensorfläche 125 durch den Benutzer 115 verwendet werden.

Die Stromquelle, ein Zähler und eine Steuerung zum Aufladen und Entladen der Kondensatoren können von einem programmierbaren Mikrocontroller umfasst sein. In einer Ausführungsform hat der Modulationskondensator etwa die 5.000-fache Kapazität des zu bestimmenden Kondensators, falls keine Berührung der Sensorfläche 125 stattfindet, und der Zähler kann bis zu $2^{13}$ Zyklen zählen. Andere Dimensionierungen sind ebenfalls möglich.

Es wird vorgeschlagen, dass die Steuereinrichtung 140 den Signalgenerator 130 dazu ansteuert, eine erste Frequenz zu verwenden. Gleichzeitig kann die Steuereinrichtung 140 am Sensorsignal der Auswertevorrichtung 135 ein Messrauschen bestimmen. Unter vorbestimmten Bedingungen, beispielsweise wenn das bestimmte Messrauschen einen vorbestimmten Schwellenwert übersteigt, kann die Steuereinrichtung 140 den Signalgenerator 130 dazu ansteuern, das Ansteuersignal mit einer zweiten Frequenz bereitzustellen. Im sich dann einstellenden Sensorsignal kann die Steuereinrichtung 140 erneut ein Messrauschen bestimmen. Anschließend kann die Steuereinrichtung 140 entscheiden, ob das Messrauschen unter Verwendung der ersten oder der zweiten Frequenz kleiner ist. Die Bestimmung der Kapazität der Sensorfläche 125 kann dann auf der Basis des Ansteuersignals mit der vorteilhaften Frequenz fortgesetzt werden.

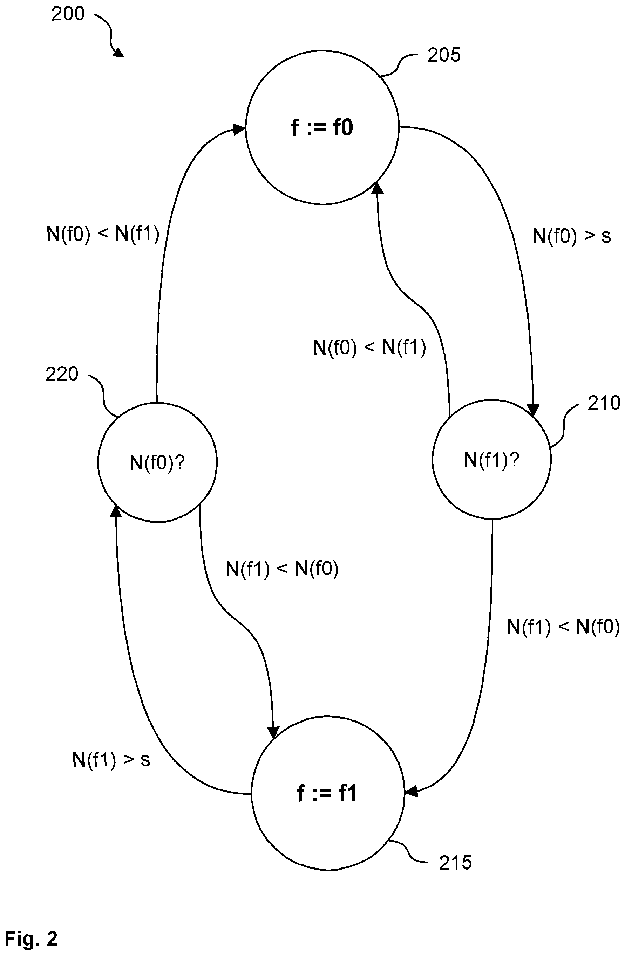

Figur 2 zeigt ein Ablaufdiagramm eines Verfahrens 200 zum Steuern eines Geräts, insbesondere eines Haushaltsgeräts 100. Das Verfahren 200 ist in Form eines Zustandsübergangssystems dargestellt. In einem ersten Zustand 205, mit dem das Verfahren 200 beginnen kann, wird eine Frequenz f0 für das Ansteuersignal des Signalgenerators 130 an die Sensorfläche 125 übernommen. Die Sensorfläche 125 wird mit dem Ansteuersignal der gewählten Frequenz angesteuert und ein Rauschen bzw. Messrauschen des Sensorsignals bei Verwendung der Frequenz f0 als primäre Frequenz kann bestimmt werden. Außerdem kann eine Filterkette, die auf die sekundäre Frequenz f1 bezogen ist, aktualisiert werden. Hierzu kann periodisch auf die sekundäre Frequenz f1 gewechselt werden.

Unter einer vorbestimmten Bedingung, beispielsweise periodisch oder wenn bestimmt wird, dass das bestimmte Messrauschen bezüglich f0 einen vorbestimmten Schwellenwert s übersteigt, kann in einem Schritt 210 ein Messrauschen bezüglich der anderen Frequenz f1 bestimmt werden. Dazu kann die Sensorfläche 125 mittels des Signalgenerators 130 mit einem Ansteuersignal der Frequenz f1 angeregt werden. Ein dabei entstehendes Sensorsignal kann auf Rauschen untersucht werden. Anschließend kann bestimmt werden, dass das Rauschen bezüglich der zuerst verwendeten Frequenz kleiner oder größer als das Rauschen bezüglich der anderen Frequenz ist. Bewirkt die erste Frequenz ein kleineres Rauschen, so kann in den Schritt 205 zurückgekehrt werden. Andernfalls, wenn die andere Frequenz ein geringeres Rauschen bewirkt, kann in einen Schritt 215 verzweigt werden.

Der Schritt 215 entspricht dem Schritt 205, jedoch wird als Frequenz des Ansteuersignals der Sensorfläche 125 die andere Frequenz f1 als primäre Frequenz gewählt. Bezüglich dieser Frequenz wird ein Messrauschen des Sensorsignals der Auswertevorrichtung 135 bestimmt. Eine Filterkette bezüglich der ersten Frequenz f0 kann aktualisiert werden.

Unter einer weiteren vorbestimmten Bedingung, beispielsweise wenn das bestimmte Messrauschen bezüglich der gewählten Frequenz f1 einen vorbestimmten Schwellenwert übersteigt, kann in einen Schritt 220 verzweigt werden. Der Schritt 220 entspricht dem Schritt 210 mit dem Unterschied, dass ein Messrauschen bezüglich der Frequenz f0 bestimmt wird. Dazu kann das Ansteuersignal mit der Frequenz f0 an die Sensorfläche 125 angelegt werden.

Ist ein dabei bestimmtes Messrauschen bezüglich der Frequenz f0 geringer als das zuvor bestimmte Messrauschen bezüglich der Frequenz f1, so kann in den Schritt 205 verzweigt werden, wo f0 als neue primäre Frequenz für das Ansteuersignal an der Sensorfläche 125 gewählt wird. Andernfalls kann das Verfahren 200 zum Schritt 215 zurückkehren, wo die Frequenz f1 für das Ansteuersignal der Sensorfläche 125 ausgewählt wird.

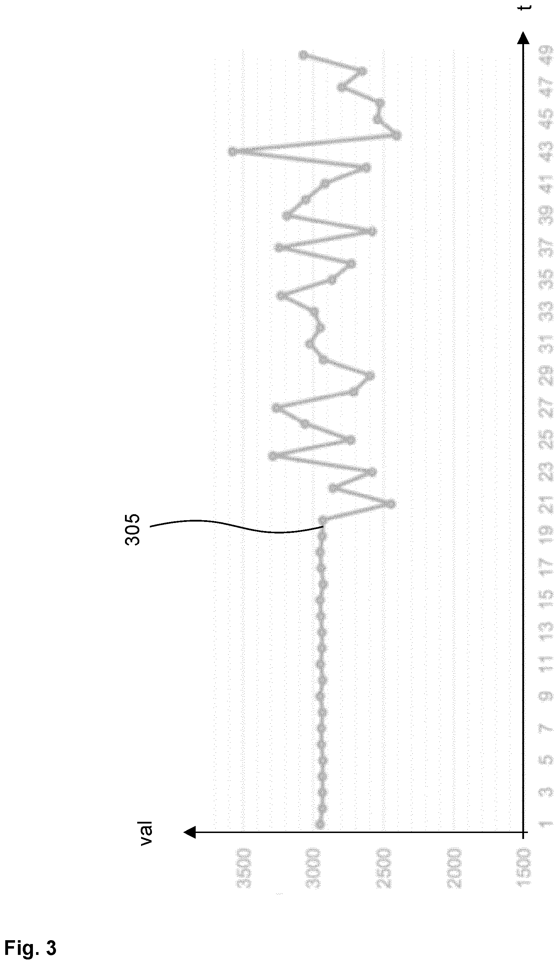

Figur 3 zeigt ein beispielhaftes Sensorsignal 305. In horizontaler Richtung sind einzelne Messungen des Sensorsignals angetragen. In vertikaler Richtung sind die Sensorsignale als Werte angetragen. Skalen beider Achsen sind als exemplarisch zu betrachten.

Zwischen Zeitpunkten 1 und 20 wird das Sensorsignal nicht von einer Störquelle beeinflusst. Die beobachteten Werte unterscheiden sich voneinander nur wenig und ein Messrauschen kann entsprechend gering sein.

Zwischen Messwerten 21 und 49 wird ein Störsignal im Bereich der Sensorfläche 125 eingekoppelt. Aufeinanderfolgende Messwerte weisen signifikant größere relative Unterschiede zueinander auf. Ein bestimmtes Messrauschen in diesem Bereich ist deutlich größer als im oben beschriebenen ersten Bereich.

Durch Wahl eines Ansteuersignals mit einer passenden Frequenz kann der Einfluss des Störsignals minimiert sein. Im dargestellten Beispiel kann die erste Frequenz f0 zum ersten Bereich zwischen den Messwerten 1 und 20 korrespondieren, und die zweite Frequenz f1 für den Bereich zwischen den Messwerten 21 und 49. Eine Berührung der Sensorfläche 125 durch einen Benutzer 115 ist in beiden Fällen nicht angenommen. In der dargestellten Ausführungsform ist bevorzugt, die Bestimmung einer Berührung auf der Basis der ersten Frequenz f0 fortzusetzen.

Bezugzeichen

| 100 | Haushaltsgerät |
| 105 | Bedienvorrichtung |
| 110 | Verbraucher |
| 115 | Benutzer |
| 120 | Bestimmungseinrichtung |
| 125 | Sensorfläche, Elektrode |
| 130 | Signalgenerator |
| 135 | Auswertevorrichtung |
| 140 | Steuereinrichtung |
| 145 | Treiber |
| | |
| 200 | Verfahren |
| 205 | Sensorfläche mit f = f0 ansteuern, Rauschen (N) bei f0 bestimmen |
| 210 | Rauschen (N) bei f1 bestimmen |
| 215 | Sensorfläche mit f = f1 ansteuern, Rauschen (N) bei f1 bestimmen |
| 220 | Rauschen (N) bei f0 bestimmen |
| | |
| 305 | Sensorsignal |

**Patentansprüche**

1. Bedienvorrichtung (105), umfassend:

   - eine Sensorfläche (125);
   - einen Signalgenerator (130) zur Bereitstellung eines Ansteuersignals mit einer vorbestimmten Frequenz;
   - eine Auswertevorrichtung (135), die dazu eingerichtet ist, ein von der Kapazität der Sensorfläche (125) abhängiges Sensorsignal bereitzustellen; und
   - eine Steuereinrichtung (140), die dazu eingerichtet ist, Messrauschen an der Auswertevorrichtung (135) unter verschiedenen Frequenzen zu bestimmen und die Frequenz des Ansteuersignals zur Bestimmung des Sensorsignals in Abhängigkeit des bestimmten Messrauschens zu wählen.

2. Bedienvorrichtung (105) nach Anspruch 1, wobei das Messrauschen am Sensorsignal bestimmt wird.

3. Bedienvorrichtung (105) nach Anspruch 1 oder 2, wobei die Steuereinrichtung (140) dazu eingerichtet ist, eine Bestimmung des Sensorsignals bei Anregung der Sensorfläche (125) mit einer primären Frequenz zu unterbrechen, um das Messrauschen bei Anregung der Sensorfläche (125) mit einer sekundären Frequenz zu bestimmen.

4. Bedienvorrichtung (105) nach Anspruch 3, wobei die Unterbrechungen periodisch erfolgen.

5. Bedienvorrichtung (105) nach einem der vorangehenden Ansprüche, wobei die Auswertevorrichtung (135) das Sensorsignal auf der Basis des Ansteuersignals mittels eines Sigma-Delta-Verfahrens bestimmt.

6. Bedienvorrichtung (105) nach einem der vorangehenden Ansprüche, ferner umfassend eine Bestimmungseinrichtung (120) zur Bestimmung einer Berührung der Sensorfläche (125) durch einen Benutzer auf der Basis des Sensorsignals.

7. Bedienvorrichtung (105) nach Anspruch 6, ferner umfassend einen Treiber (145), der dazu eingerichtet ist, einen Verbraucher (110) in Abhängigkeit der bestimmten Berührung anzusteuern.

8. Haushaltsgerät (100), umfassend eine Bedienvorrichtung (105) nach einem der vorangehenden Ansprüche.

9. Verfahren (200) mit folgenden Schritten:

   - Bereitstellen (205, 215) eines Ansteuersignals mit einer vorbestimmten Frequenz an einer Sensorfläche (125);
   - Bereitstellen (205, 215) eines von einer Kapazität der Sensorfläche (125) anhängigen Sensorsignals;
   - Bestimmen (205, 210, 215, 220) von Messrauschen an der Auswertevorrichtung (135) unter verschiedenen Frequenzen; und
   - Wählen (210, 220) der Frequenz (205, 215) des Ansteuersignals zur Bestimmung des Sensorsignals in Abhängigkeit des bestimmten Messrauschens.

10. Verfahren (200) nach Anspruch 9, wobei mehrere Frequenzen vorbestimmt sind; wobei zur Bestimmung (205, 215) des Sensorsignals eine primäre Frequenz für das Ansteuersignal verwendet wird.

11. Verfahren (200) nach Anspruch 9 oder 10, wobei das Messrauschen unter Verwenden der sekundären Frequenz erst bestimmt (210, 220) wird, wenn das Messrauschen unter Verwenden der primären Frequenz einen vorbestimmten Schwellenwert übersteigt.

**Fig. 1**

**Fig. 2**

Fig. 3

Europäisches
Patentamt

European
Patent Office

Office européen
des brevets

**EUROPÄISCHER RECHERCHENBERICHT**

Nummer der Anmeldung

EP 22 19 7048

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 2 549 651 A1 (ACER INC [TW]) 23. Januar 2013 (2013-01-23) * Absätze [0028], [0032]; Abbildungen 1, 2,5 * ----- | 1-11 | INV. H03K17/96 |
| X | US 2018/052558 A1 (WANG BO REN [US] ET AL) 22. Februar 2018 (2018-02-22) * Absatz [0075] – Absatz [0081]; Abbildungen 3, 4, 11 * ----- | 1-11 | |
| X | EP 0 818 751 A1 (SYNAPTICS INC [US]) 14. Januar 1998 (1998-01-14) * Abbildung 14 * ----- | 1-11 | |
| A | WO 2015/183461 A1 (CYPRESS SEMICONDUCTOR CORP [US]) 3. Dezember 2015 (2015-12-03) * Absätze [0031], [0036]; Abbildung 1 * ----- | 1-11 | |
| | | | RECHERCHIERTE SACHGEBIETE (IPC) |
| | | | H03K |

Der vorliegende Recherchenbericht wurde für alle Patentansprüche erstellt

| Recherchenort | Abschlußdatum der Recherche | Prüfer |
|---|---|---|
| Den Haag | 15. Februar 2023 | Loiseau, Ludovic |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

..........................................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 19 7048

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-02-2023

| Im Recherchenbericht angeführtes Patentdokument | Datum der Veröffentlichung | Mitglied(er) der Patentfamilie | Datum der Veröffentlichung |
|---|---|---|---|
| EP 2549651 A1 | 23-01-2013 | EP 2549651 A1 | 23-01-2013 |
| | | TW 201305860 A | 01-02-2013 |
| | | US 2013021267 A1 | 24-01-2013 |
| US 2018052558 A1 | 22-02-2018 | CN 109643996 A | 16-04-2019 |
| | | EP 3501106 A1 | 26-06-2019 |
| | | US 2018052558 A1 | 22-02-2018 |
| | | WO 2018034830 A1 | 22-02-2018 |
| EP 0818751 A1 | 14-01-1998 | CN 1197555 A | 28-10-1998 |
| | | EP 0818751 A1 | 14-01-1998 |
| | | KR 980010726 A | 30-04-1998 |
| | | TW 343313 B | 21-10-1998 |
| | | WO 9802964 A1 | 22-01-1998 |
| WO 2015183461 A1 | 03-12-2015 | US 2015349773 A1 | 03-12-2015 |
| | | WO 2015183461 A1 | 03-12-2015 |

EPO FORM P0461

Für nähere Einzelheiten zu diesem Anhang : siehe Amtsblatt des Europäischen Patentamts, Nr.12/82